# FASCICULE DE BREVET EUROPEEN

(11) **EP 1 373 071 B1**
(45) Date de publication et mention de la délivrance du brevet: **21.06.2006**
(21) Numéro de dépôt: 02706869.1
(22) Date de dépôt: 18.02.2002
(51) Int. Cl.: B64G 1/44, H01L 31/042

(54) **PANNEAU SOLAIRE AYANT DES BORNES ELECTRIQUES REPARTIES SUR SA SURFACE**
SOLARZELLENSTRUKTUR MIT ÜBER DER GANZEN OBERFLÄCHE VERTEILTE, ELEKTRISCHE KONTAKTE
SOLAR PANEL WITH ELECTRICAL TERMINALS DISTRIBUTED ACROSS THE SURFACE THEREOF

(30) Priorité: 21.03.2001 FR 0103822
(43) Date de publication de la demande: 02.01.2004
(73) Titulaire: ALCATEL, 75008 Paris (FR)
(72) Inventeur: BOULANGER, Bernard, F-83520 Roquebrun Sur Argens (FR)
(74) Mandataire: Hedarchet, Stéphane
(86) Numéro de dépôt international: PCT/FR2002/000611
(87) Numéro de publication internationale: WO 2002/074623

(56) Documents cités:
- DE-A- 19 836 272
- PATENT ABSTRACTS OF JAPAN vol. 015, no. 291 (E-1093), 24 juillet 1991 (1991-07-24) -& JP 03 104174 A (NEC CORP), 1 mai 1991 (1991-05-01)
- PATENT ABSTRACTS OF JAPAN vol. 018, no. 684 (E-1650), 22 décembre 1994 (1994-12-22) -& JP 06 275857 A (NEC CORP), 30 septembre 1994 (1994-09-30)
- PATENT ABSTRACTS OF JAPAN vol. 010, no. 141 (E-406), 24 mai 1986 (1986-05-24) & JP 61 004266 A (NIPPON DENKI KK), 10 janvier 1986 (1986-01-10)

## Description

L'invention concerne un panneau solaire pour satellite spatial ayant une surface plane comprenant une pluralité de cellules photovoltaïques disposées côte à côte et formant sensiblement un quadrillage, lesdites cellules étant électriquement connectées selon au moins un serpentin, chaque serpentin étant constitué de cellules connectées en série deux à deux formant des segments de cellules parallèles les uns aux autres, deux segments successifs d'un serpentin étant électriquement connectés par leurs extrémités, chaque serpentin comprenant des bornes positives et des bornes négatives.

L'invention s'applique plus particulièrement au domaine des panneaux photovoltaïques plans équipant des satellites rencontrant un environnement électrostatique sévère tels que les satellites géostationnaires, dans lesquels les cellules photovoltaïques sont par exemple montées sur un substrat. Dans un tel panneau connu du brevet EP 0 938 141, les cellules sont connectées pour former des serpentins dits en "U". Chaque serpentin a ses extrémités qui comportent des bornes positives et négatives situées sur un bord du panneau, pour que le courant produit par le serpentin soit renvoyé en direction du satellite via des câbles électriques. Dans ces panneaux connus, les bornes positives et négatives qui sont contiguës ont une forte différence de potentiel ainsi qu'un courant électrique disponible important. L'existence de ces bornes situées à de faibles distances et ayant une forte différence de potentiel favorise l'établissement d'un arc électrique permanent entre ces bornes ou entre des cellules proches de ces bornes. Cet arc électrique provoque une pyrolyse du substrat et donne lieu à un court circuit irréversible du tronçon constitué des cellules connectées entre les deux points de court circuit. Plus généralement, l'arc peut apparaître entre deux cellules adjacentes du panneau qui ont une différence de potentiel élevée. Ce phénomène se produit à la suite de l'apparition d'un arc primaire qui se forme à la suite de la charge électrostatique de la surface du panneau dite "coverglass" qui est isolante, cet arc primaire étant suffisant pour amorcer un arc permanent.

Dans le brevet EP 0 938 141, on place un matériau isolant entre les cellules adjacentes pour barrer le chemin situé entre cellules, dit gap, aux arcs primaires. D'autre part, pour réduire les conséquences d'un éventuel court-circuit, des diodes sont associées aux cellules photovoltaïques pour réduire l'intensité du courant de court-circuit à l'intensité fournie par un seul tronçon de cellules. Ces deux méthodes ne sont pas complètement satisfaisante dans la mesure où elles tendent notamment à alourdir le panneau ce qui pénalise le ratio puissance électrique/masse. D'autre part, ces deux méthodes nécessitent de faire réaliser des cellules sur mesure, ce qui accroît le coût de fabrication d'un tel panneau.

Le document JP 03104174A décrit un courant circulant dans une cellule solaire de charge. Un courant inverse dans la direction inverse à la surface de la cellule solaire.

Le but de l'invention est de remédier aux inconvénients de l'art antérieur proposant un agencement de cellules ainsi qu'un câblage permettant de réduire significativement les risques de court-circuit dans un tel panneau solaire.

A cet effet, l'invention a pour objet un panneau solaire selon la revendication 1.

Une telle construdion fait que les distances entre bornes ayant une forte différence de potentiel sont augmentées, et qu'un panneau peut être constitué de cellules ayant des tailles standard, ce qui permet d'en réduire significativement le coût de fabrication.

Selon un mode de réalisation particulier de l'invention, le panneau comprend des câbles, chaque câble partant d'une borne du panneau et s'étendant parallèlement aux segments jusqu'à un axe du panneau et langeant ensuite cet axe en formant un faisceau de câbles, pour former avec chaque serpentin des boudas de courant générant des moments magnétiques qui se compensent mutuellement. Avec cet agencement, le moment magnétique appliqué au panneau par chaque serpentin est sensiblement nul.

Selon encore un autre mode de réalisation particulier, le panneau comprend des paires de câbles plats pour récupérer un courant fourni par le panneau et le diriger vers un bord du panneau, chaque paire de câble comprenant un câble positif et un câble négatif, lesdites paires comprenant des premières paires de câbles partant du faisceau et s'étendant sur une première moitié du panneau par rapport un axe, et des secondes paires de câbles partant du faisceau et s'étendant sur une seconde moitié du panneau par rapport à l'axe, lesdites première paires de câbles ayant une longueur cumulée sensiblement identique à celle des secondes paires de câbles pour générer des moments magnétiques qui se compensent mutuellement. Avec cet agencement, le moment magnétique appliqué au panneau par les différentes paires de câbles est sensiblement nul.

Selon un autre mode de réalisation particulier, le panneau a au moins deux sections consécutives disposées le long d'un axe, chaque section étant électriquement indépendante et comprenant au moins un serpentin constitué de plusieurs segments, et deux segments contigus appartenant à deux sections consécutives comprennent chacun une borne négative, pour que deux cellules contiguës appartenant à deux sections différentes aient une différence de potentiel réduite lorsque l'une desdites sections est électriquement désactivée. Avec cet agencement, certaines sections du panneau peuvent être désactivées par un gestionnaire de puissance du satellite, sans risque d'apparition d'arc électrique.

Selon un autre mode de réalisation particulier, le panneau comprend au moins deux modules, chaque module comprenant au moins un serpentin constitué de segments, et deux modules contigus sont disposés en regard l'un par rapport à l'autre, de sorte que les extrémités de leurs segments sont contiguës, pour que lesdits segments aient une longueur réduite afin de diminuer la chute de tension le long de chaque segment. Un tel agencement est notamment adapté pour les cellules photovoltaïques présentant une tension élevée, telles que les cellules à multijonction avec concentration.

L'invention sera maintenant décrite plus en détail, et en référence aux dessins annexés qui en illustrent une forme de réalisation à titre d'exemple non limitatif.
La figure 1 est une représentation schématique d'un panneau solaire de l'art antérieur;
La figure 2 est une représentation schématique d'un autre panneau solaire de l'art antérieur;
La figure 3 est une représentation schématique du câblage arrière d'un panneau non couvert par l'invention;
La figure 4 est une représentation schématique des boucles de courant dans un panneau non couvert par l'invention;
La figure 5 est une représentation schématique d'un premier agencement de cellules avec deux serpentins entrelacés, et inversion du sens du courant dès les deux premiers segments ;
La figure 6 est une représentation schématique d'un second agencement de cellules avec trois serpentins entrelacés et inversion du sens du courant dès la première paire de segments ;
La Figure 7 est une représentation schématique de l'agencement des paires de câbles du panneau selon l'invention ;
La figure 8 est une représentation schématique d'un panneau comprenant deux sections, non couvert par l'invention;
La figure 9 est une représentation schématique d'un panneau comprenant deux modules, non couvert par l'invention.

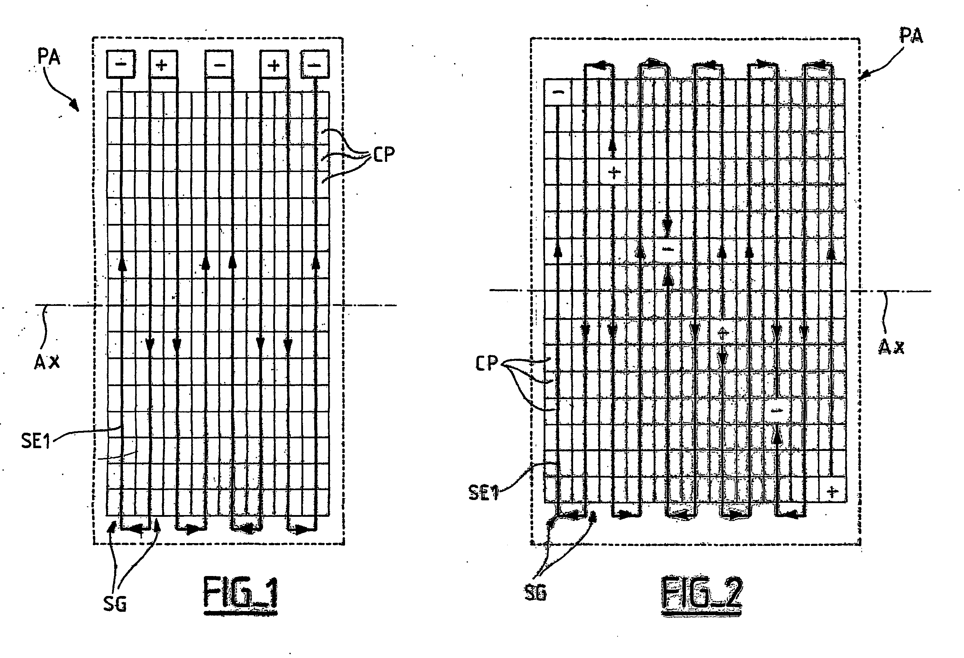

Dans la figure 1, on a représenté un panneau solaire PA connu de l'art antérieur qui a sensiblement la forme d'un rectangle plan dans lequel des cellules photovoltaïques CP carrées ou rectangulaires sont disposées les unes à côté des autres pour former sensiblement un quadrillage. Il est connu de connecter électriquement les cellules d'un tel panneau en série deux à deux selon un serpentin SE1, ce serpentin étant constitué de plusieurs segments de cellules connectées deux à deux en série. Ces segments sont parallèles entre eux, et disposés perpendiculairement à un axe AX du panneau, deux segments SG successifs étant connectés au niveau de l'une de leurs extrémités. Ce serpentin comprend ainsi plusieurs chaînes de cellules formant ici des "U" constitués de deux segments de cellules connectés au niveau de leur extrémité inférieure. Deux chaînes successives sont elles mêmes connectées en série par l'intermédiaire de bornes électriques +, - montées aux extrémités supérieures des "U" qu'elles forment. Les extrémités supérieures de chaque "U" sont chacune connectées à une borne positive + ou négative du panneau, pour que le courant électrique fourni par chaque chaîne soit collecté par des câblages non représentés et conduit en direction du satellite. Un tel panneau baigne généralement dans un champ magnétique qui est orienté dans le plan du panneau, ce qui génère un couple dû au moment magnétique crée par chaque boucle de courant, découlant de la force de Laplace. Pour annuler le moment magnétique appliqué à l'ensemble du panneau, deux "U" successifs forment des boucles de courant d'intensité identique, mais tournant en sens inverse, de sorte que le moment magnétique est nul si l'on considère deux boucles de courant successives. Ainsi, le moment magnétique global appliqué au panneau est nul pour un nombre pair de boucles. Dans ce panneau connu, deux bornes +, - qui sont associées à un même "U" sont relativement proches et ont une différence de potentiel qui vaut la chute de tension de toutes la chaîne correspondante. Ainsi, la différence de potentiel maximale apparaît entre des bornes successives, et entre les deux cellules contiguës qui sont chacune à une extrémité d'une même chaîne en "U". Il en découle que la faible distance qui sépare ces cellules (ou ces bornes) associée à une forte différence de Potentiel constitue un risque d'apparition d'arc électrique susceptible de provoquer un court-circuit d'une portion ou de la totalité de la chaîne correspondante.

Pour palier cet inconvénient, le panneau solaire qui est représenté dans la figure 2, qui n'est pas couvert par l'invention, a également une forme rectangulaire avec des cellules CE qui sont interconnectées pour former un serpentin SE1, mais les bornes positives + et négatives sont réparties le long du serpentin et sur la surface du panneau PA au lieu d'être implantées le long d'un bord du panneau comme dans l'art antérieur. Dans cet exemple de panneau les bornes sont réparties sur la diagonale que forme le panneau, mais d'autres agencements sont également envisageables, comme cela sera décrit plus loin. Dans ce panneau le serpentin SE1 est constitué de plusieurs segments 5G de cellules connectés en série et déposés parallèlement les uns aux autres, deux segments successifs SG ayant leurs extrémités connectées. Les différentes chaînes de cellules de ce serpentin sont connectées en série au niveau des bornes positives ou négatives qui sont réparties le long du serpentin. Deux chaînes successives ont leurs cellules agencées pour que le courant circule en sens inverse, de sorte qu'une borne connectée à deux chaînes successives collecte le courant issu de chacune de ces deux chaînes, comme dans le panneau de l'art antérieur présenté dans la figure 1.

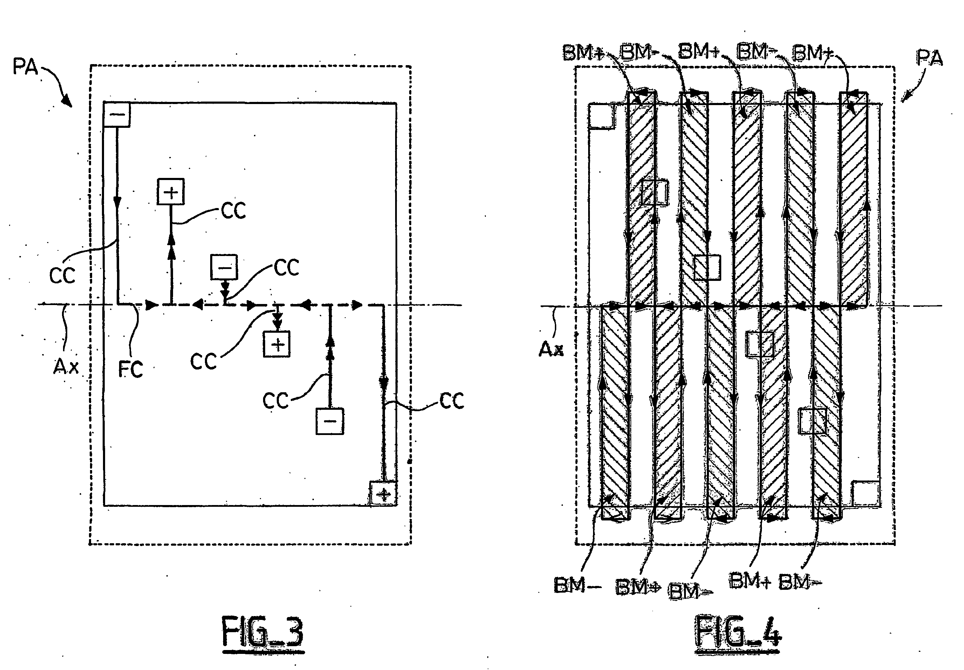

En variante, et pour compenser le moment magnétique, la face arrière du panneau comprendra un câblage destiné à ramener le courant disponibles sur les différentes bornes du panneau vers l'axe AX. Comme visible sur la figure 3, non couverte par l'invention, ce câblage comprend plusieurs câbles CC, chaque câble partant d'une borne pour rejoindre l'axe AX en longeant le segment de cellules sur lequel se situe la borne dont il est issu. Chaque câble court ensuite le long de l'axe pour former un faisceau de câbles FC et être ensuite collecté depuis ce faisceau FC par des paires de câbles non représentées dans la figure 3. Un tel câblage permet de compenser les moments magnétiques en formant des boucles de courant qui tournent en sens inverse pour se compenser mutuellement. Ces boucles de courant BM+, BM- qui ont été représentées dans la figure 4 sont chacune formées par deux demi-segments de cellules consécutifs qui ont une extrémité interconnectée, et par la portion correspondante du faisceau FC qui court le long de l'axe. Plus particulièrement, les câbles CC qui relient une borne à l'axe sont parcourus par un courant qui circule en sens inverse du courant circulant dans les cellules qu'il longe, comme visible sur les figures 2 et 3. L'intensité du courant circulant dans un tel câble CC est la même que celle circulant dans les cellules qu'il longe si ce câble est issu d'une borne connectée à une seule chaîne de cellules comme la première ou la dernière borne du serpentin. Cette intensité est double si ce câble est issu d'une borne connectée à deux chaînes de cellules, comme visible sur la figure 3. La superposition du courant circulant dans les cellules et du courant circulant dans les câbles forme ainsi les boucles de courant BM+, BM- tournant en sens inverse, de sorte que les moments magnétiques qu'elles génèrent s'annulent mutuellement, comme représenté dans la figure 4. Dans cette variante, le panneau selon l'invention est agencé pour augmenter la distance entre bornes et cellules à forte différence de potentiel, tout en étant soumis à un moment magnétique global sensiblement nul grâce à son câblage en face arrière.

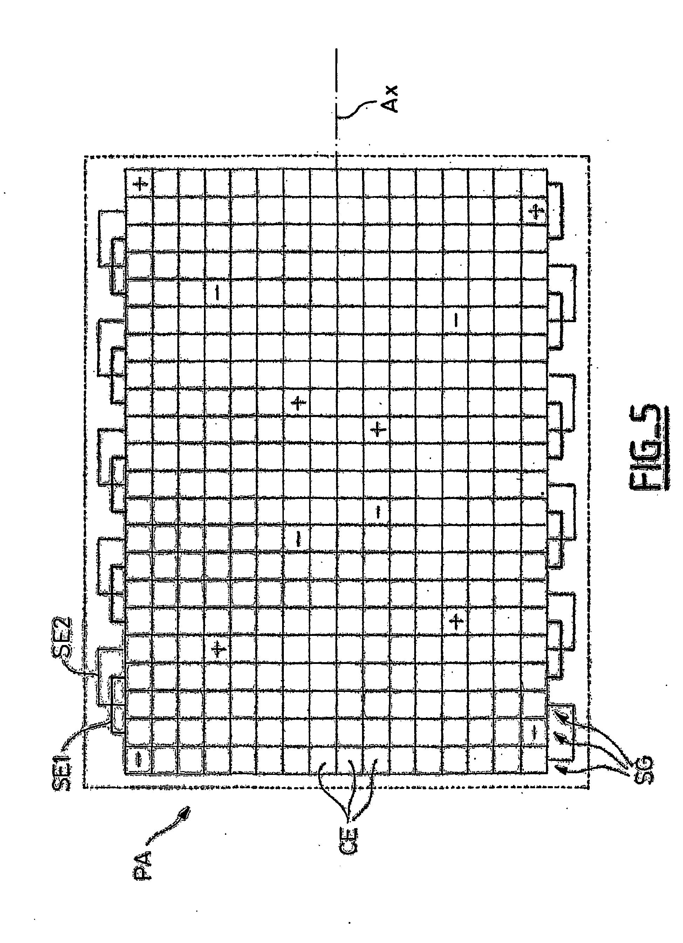

Le panneau selon l'invention comprend plusieurs serpentins de cellules entrelacés, pour réduire encore la différence de potentiel de deux cellules contiguës. Comme représenté dans la figure 5, le panneau est constitué de segments SG de cellules disposés parallèlement les uns aux autres pour former un panneau rectangulaire. Le premier serpentin SE1 est constitué du premier segment de cellules qui est connecté au troisième segment, lui même connecté au cinquième segment, etc. et le second serpentin SE2 est constitué du second segment de cellules qui est connecté au quatrième segment etc., de telle manière que deux segments de cellules contigus appartiennent à deux serpentins différents. Le sens du courant est inversé entre les deux serpentins dès les deux premiers segments. Dans ce panneau, la différence de potentiel maximale entre deux cellules contiguës apparaît au niveau des cellules situées sur le bord inférieur ou supérieur du panneau, mais les serpentins sont agencés de manière symétrique par rapport à l'axe AX du panneau. Ainsi, la différente de potentiel entre deux cellules situées sur le bord du panneau est limitée à la valeur de la chute de tension d'un segment de cellules. Plus particulièrement, le serpentin SE2 est obtenu par symétrie axiale par rapport à l'axe AX du serpentin SE1 puis par translation selon l'axe AX sur une longueur d'une cellule. Comme pour le panneau représenté dans les figures 2, 3 et 4, ce panneau qui comprend deux serpentins SE1, SE2 pourra être équipé d'un câblage en face arrière permettant d'annuler le moment magnétique global appliqué au panneau.

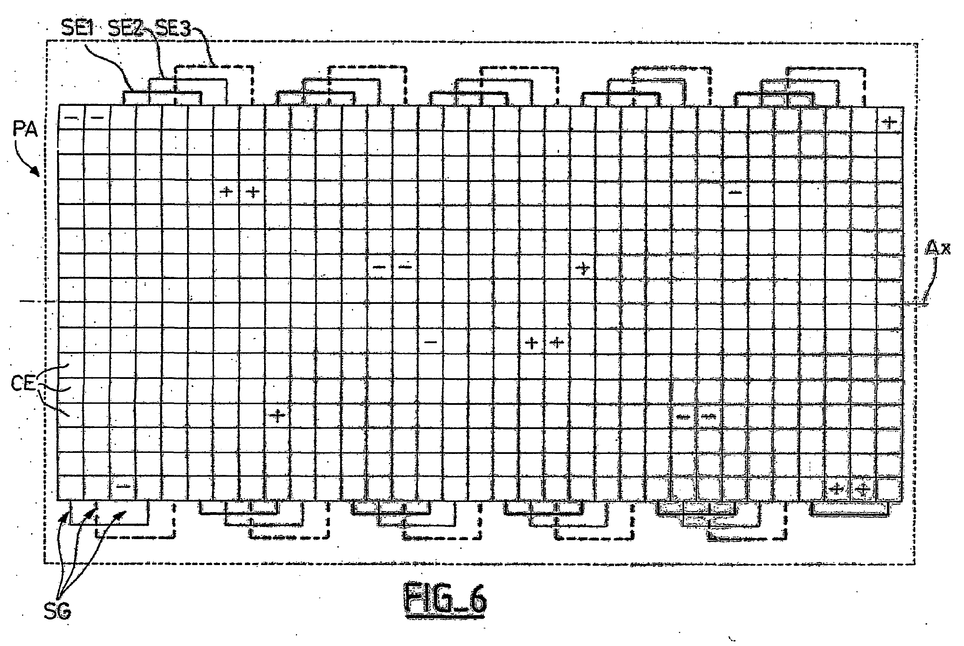

Dans une variante d'entrelacement qui est représentée sur la figure 6, le panneau comprend trois serpentins SE1, SE2, SE3 qui sont entrelacés. Dans cette variante, on a disposé deux serpentins SE1 et SE2 comme pour le panneau de la figure 5, mais le serpentin SE2 est doublé par le serpentin SE3, ce pour bénéficier des avantages de la diminution de la tension de deux cellules contiguës décrits ci-dessus, tout en augmentant la surface du panneau, Ainsi, le serpentin SE2 est obtenu par symétrie et translation du serpentin SE1, et le serpentin SE3 est une réplique du serpentin SE2 translatée selon l'axe AX d'une longueur d'une cellule. Comme montré sur l'exemple de la figure 6, le sens du courant dans le premier segment du troisième serpentin SE3 est inversé par rapport au sens du courant dans les premiers segments des deux serpentins SE1 et SE2. Il va de soi que d'autres variantes peuvent être envisagées sur ce modèle, pour entrelacer par exemple quatre ou cinq serpentins de cellules dans un même panneau.

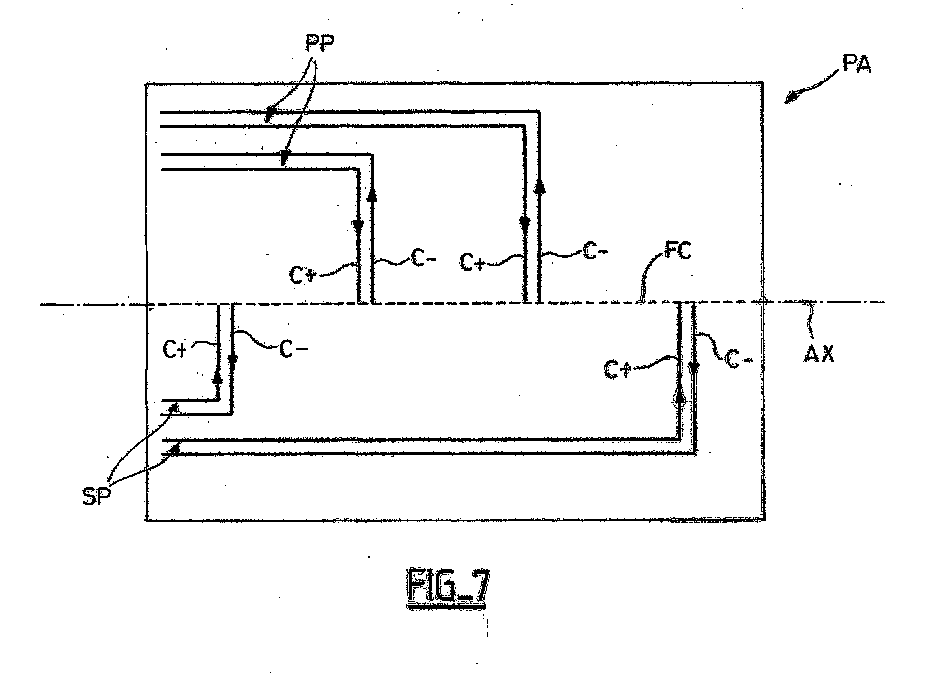

Pour récupérer le courant produit par les chaînes de cellules et le conduire vers le satellite, le panneau pourra être équipé sur sa face arrière de paires de câbles telles que représentées dans la figure 7. Ces paires de câbles PP, SP sont constituées de câbles plats C+, C- ou de câbles montés à plat tels que des câbles en nappes. Comme visible sur la figure 7, le panneau comprend des premières paires de câbles PP qui partent du faisceau FC et s'étendent sur une première moitié du panneau par rapport à l'axe AX pour rejoindre un bord du panneau. Des secondes paires de câbles SP partent également du faisceau FC mais s'étendent sur une seconde moitié du panneau par rapport à l'axe AX pour rejoindre également le bord du panneau. Les premières paires de câbles et les secondes paires de câbles ont leurs polarités inversées pour former des boucles de courant tournant en sens inverse de part et d'autre de l'axe, en vue de compenser mutuellement les moments magnétiques qu'elles génèrent. Plus particulièrement, les premières paires de câbles ont une longueur cumulée qui est sensiblement identique à la longueur cumulée des secondes paires de câbles, de sorte que les moments magnétiques générés sur la première moitié du panneau et sur la seconde moitié du panneau s'annulent mutuellement.

Pour agencer un nombre impair de paires de câbles tout en générant un moment magnétique globalement nul, on pourra par exemple modifier les écartements séparant les câbles de chaque paire de câble. Ainsi, pour trois paires de câbles ayant la même longueur, en agençant les deux paires selon la même polarité et le même écartement, la troisième paire pourra compenser les deux premières en ayant une polarité inversée par rapport à celles-ci et un écartement double. Un agencement similaire pourra évidemment résoudre tous les cas de figures dons lesquels on a un nombre impair de paires de câbles.

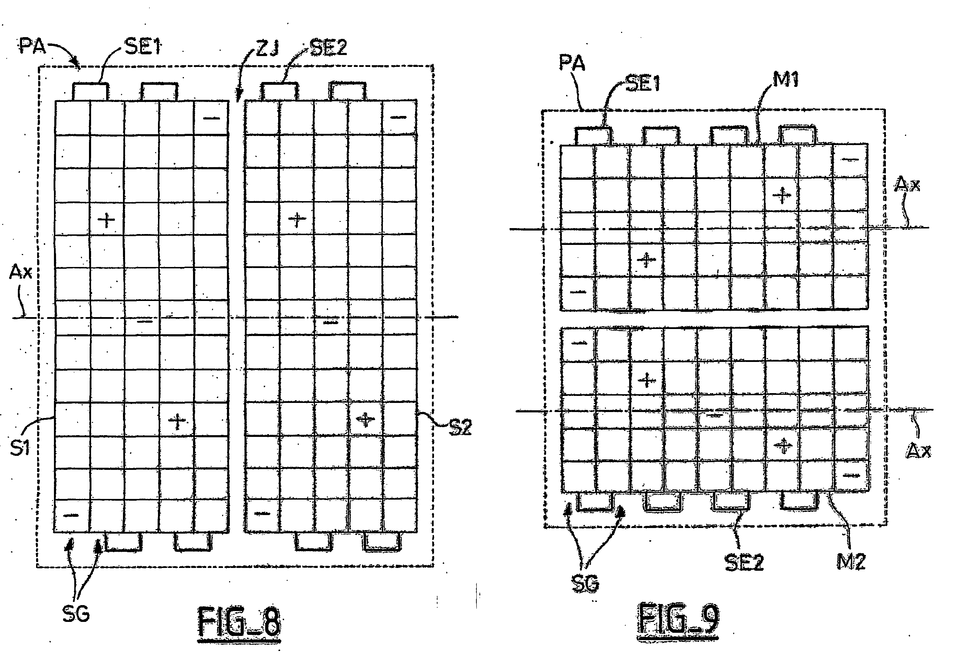

En variante, le panneau selon l'invention pourra comprendre plusieurs sections électriquement indépendantes, pour permettre une gestion de la puissance électrique par un système de gestion du satellite. Comme visible dans la figure 8, non couvert par l'invention, chaque section S1, S2 comprend au moins un serpentin SE1, SE2, pour former une unité électriquement indépendante. Les sections consécutives S1 et S2 sont disposées le long de l'axe AX, de telle manière qu'elles ont un bord commun ZJ, le long duquel se trouvent côte à côte des cellules appartenant à des sections consécutives. Dans le cas où l'une des sections est inhibée par le système de gestion, toutes ses cellules de cette section sont à un potentiel nul, de sorte qu'une différence de potentiel élevée peut apparaître entre deux cellules du bord commun Z1. Pour réduire la différence de potentiel dans cette zone, les segments du bord commun comprennent une borne négative, ainsi, comme une borne négative est nécessairement à un potentiel nul, la différence de potentiel le long d'un bord commun Z1 est réduite à la chute de tension d'un segment SG. Dons l'exemple illustré par la figure 8, le panneau PA comprend deux sections, mais il va de soi que cette variante s'applique tout aussi bien à un panneau comprenant plus de deux sections.

Selon une autre variante, le panneau selon l'invention pourra comprendre plusieurs modules, chaque module ayant au moins un serpentin, en vue de réduire la longueur des segments du panneau pour diminuer la chute de tension entre deux extrémités d'un segment. Comme visible dons la figure 9, non couvert par l'invention, les modules M1, M2 sont alors disposés en regard l'un par rapport à l'autre, pour avoir les extrémités des segments SG qui constituent leurs serpentins respectifs SE1, SE2 contiguës. Dans la variante représentée, on a disposé dans un même panneau PA deux modules qui définissent chacun un axe AX parallèles, ce qui permet de diviser par deux la longueur des segments SG. En disposant trois modules de façon similaire, la chute de tension de chaque segment SG est divisée par trois, pour un nombre de cellules sensiblement identique. Cette variante s'appliqua par exemple oux cellules à haut rendement, pour lesquelles la différence de potentiel est supérieure à la différence de potentiel des cellules classiques, ce qui tend à augmenter le risque d'apparition d'un arc électrique. D'autre part, comme visible dans la figure 9, pour réduira la différence de potentiel de deux cellules contiguës qui appartiennent à des modules différents, les serpentins de chaque module seront alors agencés de manière symétrique par rapport à l'axe défini par la zone de jonction des deux modules M1 et M2. Ainsi, la différence de potentiel de deux cellules contiguës appartenant à deux modules distincts est proche de zéro.

Plus généralement, un panneau solaire pourra par exemple être constitué de plusieurs sections, s'étendant le long d'un axe longitudinal AX, et chacune de ces sections pourra comprendre plusieurs modules s'étendant perpendiculairement à l'axe AX. Un tel panneau solaire est alors constitué d'une matrice de modules, chaque module comprenant une pluralité de cellules interconnectées selon un ou plusieurs serpentins.

Le panneau selon l'invention permet donc de réduire significativement les risques de court-circuit de certaines portions de serpentins de cellules, et avec les différentes variantes de réalisation, le moment magnétique global appliqué au panneau est sensiblement nul.

## Revendications

1. Panneau solaire pour satellite spatial ayant une surface plane comprenant une pluralité de cellules photovoltaïques (CE) disposées côte à côte et formant sensiblement un quadrillage, lesdites cellules (CE) étant électriquement connectées selon au moins un serpentin (SE1, SE2, SE3), chaque serpentin étant constitué de cellules (CE) connectées en série deux à deux formant des segments de cellules (SG) parallèles les uns aux autres, deux segments (SG) successifs d'un serpentin étant électriquement connectés par leurs extrémités, chaque serpentin comprenant des bornes positives (+) et des bornes négatives (-), lesdites bornes positives (+) et négatives (-) étant réparties le long de chaque serpentin (SE1, SE2, SE3) et sur la surface du panneau pour que les bornes positives soient éloignées des bornes négatives, afin de diminuer un risque d'apparition d'arc électrique entre deux bornes ; et **caractérisé en ce que** ledit panneau comprend plusieurs serpentins (SE1, SE2, SE3) entrelacés et agencés de façon sensiblement symétrique par rapport à un axe (AX) du panneau, ledit axe étant perpendiculaire auxdits segments (SG), deux segments contigus (SG) du panneau appartenant à deux serpentins différents, **caractérisé en ce que** le sens du courant est inversé dès les premières paires de segments contigus pour que chaque paire de cellules contiguës ait une différence de potentiel inférieure à la chute de tension d'un segment de cellules, afin de diminuer un risque d'apparition d'arc électrique entre cellules contiguës.

2. Le panneau selon la revendication 1 comprenant des câbles, chaque câble partant d'une borne (+, -) du panneau et s'étendant parallèlement auxdits segments (SG) jusqu'audit axe (AX) du panneau et longeant ensuite ledit axe en formant un faisceau de câbles (FC), pour former avec chaque serpentin (SE1, SE2, SE3) des boucles de courant (BM+, BM-) générant des moments magnétiques qui se compensent mutuellement.

3. Le panneau selon la revendication 2, comprenant des paires de câbles plats (PP, SP) ou de câbles montés à plat pour récupérer un courant fourni par le panneau et le diriger vers un bord du panneau, chaque paire de câble (PP, SP) comprenant un câble positif (C+) et un câble négatif (C-), lesdites paires comprenant des premières paires de câbles (PP) partant du faisceau (FC) et s'étendant sur une première moitié du panneau par rapport à l'axe (AX), et des secondes paires de câbles (SP) partant du faisceau (FC) et s'étendant sur une seconde moitié du panneau par rapport à l'axe (AX), lesdites première paires de câbles ayant une longueur cumulée sensiblement identique à celle des secondes paires de câbles pour générer des moments magnétiques qui se compensent mutuellement.

4. Panneau solaire selon l'une des revendication 1 à 3, ayant au moins deux sections consécutives (S1, S2) disposées le long d'un l'axe (AX), chaque section étant électriquement indépendante et comprenant au moins un serpentin (SE1, SE2) constitué de plusieurs segments (SG), et dans lequel deux segments contigus appartenant à deux sections consécutives comprennent chacun une borne négative (B-), pour que deux cellules contiguës appartenant à deux sections différentes aient une différence de potentiel réduite lorsque l'une desdites sections est électriquement désactivée.

5. Panneau solaire selon l'une des revendications 1 à 4, ayant au moins deux modules (M1, M2), chaque module comprenant au moins un serpentin (SE1, SE2) constitué de segments (SG), et dans lequel deux modules contigus sont disposés en regard l'un par rapport à l'autre, de sorte que les extrémités de leurs segments sont contiguës, pour que lesdits segments aient une longueur réduite afin de diminuer la chute de tension le long de chaque segment.

## Claims

1. Solar panel for space satellites, having a plane surface comprising a plurality of photovoltaic cells (CE) disposed side-by-side and substantially forming a grid, said cells (CE) being electrically connected into at least one serpentine (SE1, SE2, SE3), each serpentine comprising cells (CE) connected in series two-by-two forming parallel cell segments (SG), two successive segments (SG) of a serpentine being electrically connected at their ends, and each serpentine comprising positive terminals (+) and negative terminals(-), said positive (+) and negative (-) terminals being distributed along each serpentine (SE1, SE2, SE3) and over the surface of the panel so that the positive terminals are far away from the negative terminals, to reduce the risk of electrical arcing between two terminals; and **characterised in that** said panel comprises a plurality of serpentines (SE1, SE2, SE3) interlaced and arranged substantially symmetrically with respect to an axis (AX) of the panel, said axis being perpendicular to said segments (SG), and two contiguous segments (SG) of the panel belonging to two different serpentines, which solar panel is **characterised in that** the direction of the current is reversed starting from the first pair of contiguous segments so that each pair of contiguous cells has a potential difference less than the voltage drop of a segment of cells, in order to reduce the risk of electrical arcing between contiguous cells.

2. Panel according to claim 1, comprising cables each departing from a terminal (+, -) of the panel and extending parallel to said segments (SG) as far as said axis (AX) of the panel and then running along said axis, forming a bundle of cables (FC), to form with each serpentine (SE1, SE2, SE3) current loops (BM+, BM-) generating magnetic moments that cancel each other out.

3. Panel according to claim 2, comprising pairs of flat cables (PP, SP) or cables mounted flat to recover a current supplied by the panel and direct it towards an edge of the panel, each cable pair (PP, SP) comprising a positive cable (C+) and a negative cable (C-), said pairs comprising first cable pairs (PP) departing from the bundle (FC) and extending over a first half of the panel relative to the axis (AX) and second cable pairs (SP) departing from the bundle (FC) and extending over a second half of the panel relative to the axis (AX), and said first cable pairs having a cumulative length substantially identical to that of the second cable pairs to generate magnetic moments that cancel each other.

4. Solar panel according to any one of claims 1 to 3, having at least two consecutive sections (S1, S2) disposed along the axis (AX), each section being electrically independent and comprising at least one serpentine (SE1, SE2) constituted of a plurality of segments (SG), and in which solar panel two contiguous segments belonging to two consecutive sections each comprise a negative terminal B-, so that two contiguous cells belonging to two different sections have a reduced potential difference if one of said sections is electrically deactivated.

5. Solar panel according to any one of claims 1 to 4, having at least two modules (M1, M2), each module comprising at least one serpentine (SE1, SE2) constituted of segments (SG), and in which solar panel two contiguous modules are disposed facing each other, so that the ends of their segments are contiguous, so that said segments have a reduced length in order to reduce the voltage drop along each segment.

## Patentansprüche

1. Solarzellenpanel für Weltraum-Satelliten mit einer ebenen Oberfläche, bestehend aus einer Vielzahl von Fotozellen (CE), die nebeneinander angeordnet sind und praktisch ein quadratisches Liniennetz bilden, wobei die genannten Zellen (CE) elektrisch in mindestens einer Schlange (SE1, SE2, SE3) verbunden sind, wobei jede Schlange aus paarweise in Reihe verbundenen Zellen (CE) besteht, die parallel zueinander angeordnete Zellensegmente (SG) bilden, wobei zwei aufeinander folgende Segmente (SG) einer Schlange an ihren Enden elektrisch verbunden sind, wobei jede Schlange positive Kontakte (+) und negative Kontakte (-) umfasst, wobei die genannten positiven (+) und negativen (-) Kontakte über jede Schlange (SE1, SE2, SE3) und die Paneloberfläche verteilt sind, so dass die positiven Kontakte von den negativen Kontakten entfernt sind, um die Gefahr des Auftretens eines Lichtbogens zwischen zwei Kontakten zu verringern, **dadurch gekennzeichnet, dass** das genannte Panel mehrere ineinander verschlungene Schlangen (SE1, SE2, SE3) umfasst, die praktisch symmetrisch zu einer Achse (AX) des Panels angeordnet sind, wobei die genannte Achse senkrecht zu den genannten Segmenten (SG) verläuft, wobei zwei benachbarte Segmente (SG) des Panels zu zwei verschiedenen Schlangen gehören, sowie **dadurch gekennzeichnet, dass** die Stromrichtung ab den ersten benachbarten Segmentpaaren entgegengesetzt ist, damit jedes benachbarte Zellenpaar eine Potenzialdifferenz aufweist, die niedriger ist als der Spannungsabfall eines Zellensegments, um die Gefahr des Auftretens eines Lichtbogens zwischen benachbarten Zellen zu verringern.

2. Das Panel gemäß Anspruch 1, das Kabel umfasst, wobei jedes Kabel von einem Kontakt (+, -) des Panels ausgeht und sich parallel zu den genannten Segmenten (SG) bis zur genannten Panelachse (AX) erstreckt und anschließend entlang der genannten Achse verläuft und dabei einen Kabelstrang (FC) bildet, um mit jeder Schlange (SE1, SE2, SE3) Stromschleifen (BM+, BM-) zu erstellen, die magnetische Momente erzeugen, die sich gegenseitig aufheben.

3. Das Panel gemäß Anspruch 2, das flache Kabelpaare (PP, SP) oder flach montierte Kabel umfasst, um den vom Panel gelieferten Strom zu sammeln und ihn an den Rand des Panels zu leiten, wobei jedes Kabelpaar (PP, SP) ein positives Kabel (C+) und ein negatives Kabel (C-) umfasst, wobei die genannten Paare aus ersten Kabelpaaren (PP), die von dem Kabelstrang (FC) ausgehen und sich über die erste Hälfte des Panels in Bezug zur Achse (AX) erstrecken, und aus zweiten Kabelpaaren (SP9) bestehen, die von dem Kabelstrang (FC) ausgehen und sich über die zweite Hälfte des Panels in Bezug zur Achse (AX) erstrecken, wobei die genanten ersten Kabelpaare und die zweiten Kabelpaare eine praktisch identische Gesamtlänge aufweisen, um magnetische Momente zu erzeugen, die sich gegenseitig aufheben.

4. Solarzellenpanel gemäß einem der Ansprüche 1 bis 3, das mindestens zwei aufeinander folgende Abschnitte (S1, S2) aufweist, die entlang einer Achse (AX) angeordnet sind, wobei jeder Abschnitt elektrisch unabhängig ist und mindestens eine Schlange (SE1, SE2, SE3) umfasst, die aus mehreren Segmenten (SG) besteht, und in dem zwei benachbarte Segmente, die zu zwei aufeinander folgenden Abschnitten gehören, jeweils einen negativen Kontakt (B-) umfassen, damit zwei benachbarte Zellen, die zu zwei verschiedenen Abschnitten gehören, eine verringerte Potenzialdifferenz aufweisen, wenn einer der genannten Abschnitte elektrisch deaktiviert wird.

5. Solarzellenpanel gemäß einem der Ansprüche 1 bis 4, das mindestens zwei Module (M1, M2) aufweist, wobei jedes Modul mindestens eine Schlange (SE1, SE2) umfasst, die aus Segmenten (SG) besteht, und in dem zwei benachbarte Module so zueinander angeordnet sind, dass die Enden ihrer Segmente benachbart sind, damit die genannten Segmente eine geringere Länge aufweisen, um den Spannungsabfall über jedem Segment zu reduzieren.
